# EUROPEAN PATENT SPECIFICATION

(11) **EP 3 264 071 B1**
(45) Date of publication and mention of the grant of the patent: **15.04.2026**
(21) Application number: 15883204.8
(22) Date of filing: 26.02.2015
(51) Int. Cl.: G01N 21/88, G01N 21/94, G01N 21/95, H05K 13/08, G01N 21/952

(54) **INSPECTION DEVICE AND INSPECTION METHOD**
INSPEKTIONSVORRICHTUNG UND INSPEKTIONSVERFAHREN
DISPOSITIF D'INSPECTION ET PROCÉDÉ D'INSPECTION

(43) Date of publication of application: 03.01.2018
(73) Proprietor: FUJI Corporation, Chiryu Aichi (JP)
(72) Inventor: IBE, Tadakatsu, Chiryu-shi Aichi (JP); SUZUKI, Daisuke, Chiryu-shi Aichi (JP); SHIMOSAKA, Kenji, Chiryu-shi Aichi (JP); HOSHIKAWA, Kazumi, Chiryu-shi Aichi (JP)
(74) Representative: Grünecker Patent- und Rechtsanwälte PartG mbB
(86) International application number: PCT/JP2015/055527
(87) International publication number: WO 2016/135910

(56) References cited:
- JP-A- 2004 349 346
- JP-A- 2011 086 847
- JP-A- 2012 004 306
- JP-A- 2012 004 306
- JP-A- 2012 243 276
- JP-A- 2013 044 663
- JP-A- 2013 143 419
- JP-A- 2014 048 073

## Description

### Technical Field

The present invention relates to an inspection device and an inspection method for inspecting an inspection target object based on light with which the inspection target object is irradiated.

### Background Art

As described in the following patent literature PTL 1, in the inspection device, when the inspection target object is irradiated with light from both lateral lighting and vertical lighting, the inspection target object is imaged based on the light which is reflected by the inspection target object, and inspection of the inspection target object is performed based on an image which is obtained using the imaging.

A further example of an inspection device is disclosed in JP 2011 086847 A.

Other examples of inspecting devices are disclosed in JP 2013 143419 A and, in particular for the inspection of the flat end surface of suction nozzles, in JP2012004306 A.

PTL 1: JP-A-2004-349346

### Summary of Invention

### Technical Problem

According to the inspection device described in the above patent literature, it is possible to inspect the inspection target object to an extent. However, there is a case in which it is not possible to appropriately image a predetermined position of the inspection target object due to the shape or the like of the inspection target object. Specifically, for example, when the inspection target object is a suction nozzle and the suction nozzle is irradiated with the lighting of both the lateral lighting and the vertical lighting as is described in the above patent literature, in a case in which imaging based on the light which is reflected on a lower end face of the suction nozzle (hereinafter, there is a case in which this is denoted as "full irradiation imaging") is performed, the image of the outer edge side or the inner edge side of the lower end face of the suction nozzle becomes clear. Meanwhile, the image of the lower end face of the suction nozzle generally becomes unclear. Therefore, in a case in which the inspection of the suction nozzle is performed using the image obtained when the full irradiation imaging is performed, it is possible to appropriately determine the adhesion of foreign matter such as dust and solder to the outer edge side or the inner edge side of the lower end face of the suction nozzle; however, there is a concern that it may not be possible to appropriately determine the adhesion of foreign matter to the lower end face of the suction nozzle, the lower end face of the suction nozzle being missing, or the like. The present invention is made in consideration of such issues, and an object of the present invention is to appropriately perform the inspection of the inspection target object.

### Solution to Problem

The present invention, solving the problem described above, is defined in the independent claims 1 and 4.

Preferred embodiments are laid down in the dependent claims.

### Advantageous Effects of Invention

The inspection device of the present invention performs full irradiation imaging, and vertical irradiation imaging which is imaging of an inspection target object based on light which is reflected by the inspection target object when the inspection target object is irradiated from vertical lighting without being irradiated from lateral lighting, and, optionally, lateral irradiation imaging which is imaging of the inspection target object based on light which is reflected by the inspection target object when the inspection target object is irradiated from the lateral lighting without being irradiated from the vertical lighting In this manner, at least two kinds of lighting pattern of lighting with which the inspection target object is irradiated are prepared, and inspection of the inspection target object is performed based on images which are captured using the two or more kinds of lighting pattern. Accordingly, it is possible to perform the inspection of the inspection target object according to the merits and the demerits of each kind lighting pattern and to appropriately perform the inspection of the inspection target object.

### Brief Description of Drawings

[Fig. 1] Fig. 1 is a perspective view illustrating an electronic component mounting device.
[Fig. 2] Fig. 2 is a perspective view illustrating a suction nozzle.
[Fig. 3] Fig. 3 is a perspective view illustrating a nozzle management device.
[Fig. 4] Fig. 4 is a schematic diagram illustrating an imaging device of the present invention.
[Fig. 5] Fig. 5 is a diagram illustrating an image of a perspective from under the suction nozzle in an ordinary state.
[Fig. 6] Fig. 6 is a diagram illustrating an image of a perspective from under the suction nozzle in a state in which foreign matter adheres to an outer edge side of a lower end face.
[Fig. 7] Fig. 7 is a diagram illustrating an image of a perspective from under the suction nozzle in a state in which foreign matter adheres to a lower end face.
[Fig. 8] Fig. 8 is a diagram illustrating an image of a perspective from under the suction nozzle in a state in which the lower end face is missing.
[Fig. 9] Fig. 9 is a diagram illustrating an image of a perspective from a side of the suction nozzle.

### Description of Embodiments

Hereinafter, a detailed description will be given of the example of the present invention with reference to the drawings as an embodiment of the present invention.

### <Configuration of Electronic Component Mounting Device>

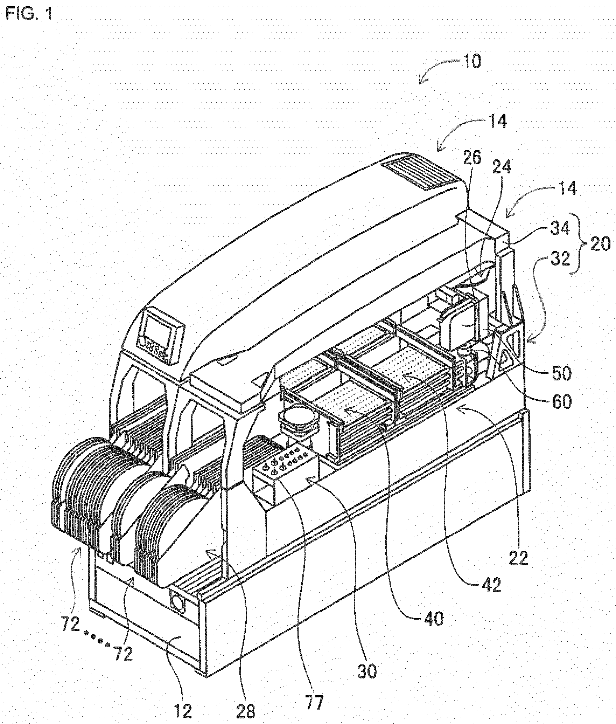

Fig. 1 illustrates an electronic component mounting device (hereinafter there is a case in which this is shortened to "mounting device") 10. The mounting device 10 includes a single system base 12 and two electronic component mounting machines (hereinafter, there is a case in which this is shortened to "mounting machines") 14 which are provided adjacently on the system base 12. The direction in which the mounting machines 14 are lined up will be referred to as an X-axis direction and a horizontal direction which is perpendicular to the direction will be referred to as a Y-axis direction.

Each of the mounting machines 14 is mainly provided with a mounting machine main body 20, a conveyance device 22, a mounting head moving device (hereinafter, there is a case in which this is shortened to a "moving device") 24, a mounting head 26, a supply device 28, and a nozzle station 30. The mounting machine main body 20 is configured using a frame section 32 and a beam section 34 which bridges over the frame section 32.

The conveyance device 22 is provided with two conveyor devices 40 and 42. The two conveyor devices 40 and 42 are installed on the frame section 32 to be parallel to each other and to extend in the X-axis direction. The two conveyor devices 40 and 42 convey circuit boards which are supported by the conveyor devices 40 and 42 in the X-axis direction using an electromagnetic motor (not illustrated). The circuit board is held in a fixed manner at a predetermined position by a board holding device (not illustrated).

The moving device 24 is an XY robot-type moving device. The moving device 24 is provided with an electromagnetic motor (not illustrated) which causes a slider 50 to slide in the X-axis direction and an electromagnetic motor (not illustrated) which causes the slider 50 to slide in the Y-axis direction. The mounting head 26 is attached to the slider 50, and the mounting head 26 is caused to move to an arbitrary position above the frame section 32 by the operation of the two electromagnetic motors.

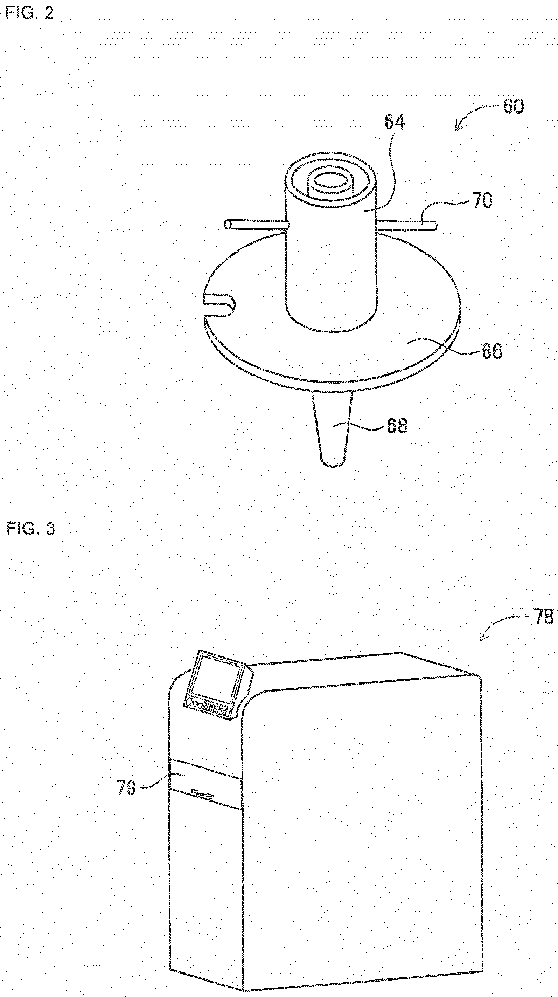

The mounting head 26 mounts the electronic component onto the circuit board. A suction nozzle 60 is provided on the lower end face of the mounting head 26. As illustrated in Fig. 2, the suction nozzle 60 is configured using a body cylinder 64, a flange section 66, a suction pipe 68, and a locking pin 70. The body cylinder 64 is cylindrical, and the flange section 66 is fixed to protrude from the outer circumferential surface of the body cylinder 64. The suction pipe 68 is a narrow pipe shape and is held by the body cylinder 64 to be capable of moving in an axial line direction in a state of extending downward from the lower end portion of the body cylinder 64. The locking pin 70 is provided on the upper end portion of the body cylinder 64 so as to extend in the radial direction of the body cylinder 64. The suction nozzle 60 is attached to the mounting head 26 to be capable of being attached and detached in a single operation using the locking pin 70. A spring (not illustrated) is embedded in the mounting head 26, and the spring applies an elastic force to the suction pipe 68 of the suction nozzle 60 which is attached to the mounting head 26. Accordingly, the suction pipe 68 is biased in a direction extending downward from the lower end portion of the body cylinder 64 by the elastic force of the spring which is embedded in the mounting head 26.

The suction nozzle 60 communicates with a positive and negative pressure supply device (not illustrated) via negative pressure air and positive pressure air passage. Each of the suction nozzles 60 sucks and holds an electronic component using a negative pressure and releases the held electronic component using a positive pressure. The mounting head 26 includes a nozzle lifting and lowering device (not illustrated) which lifts and lowers the suction nozzle 60. The mounting head 26 changes the position of the held electronic component in the up-down direction using the nozzle lifting and lowering device.

The supply device 28 is a feeder-type supply device and, as illustrated in Fig. 1, is installed on the end portion of the front side of the frame section 32. The supply device 28 includes a tape feeder 72. The tape feeder 72 accommodates taped components in a wound state. The taped components are obtained by taping the electronic components. The tape feeder 72 feeds out the taped components using a feed device (not illustrated). Accordingly, the feeder-type supply device 28 supplies the electronic components to the supply position by feeding out the taped components.

The nozzle station 30 includes a nozzle tray 77 which accommodates the multiple suction nozzles 60. In the nozzle station 30, the exchanging of the suction nozzle 60 which is attached to the mounting head 26 with the suction nozzle 60 which is accommodated in the nozzle tray 77, and the like are performed as necessary. The nozzle tray 77 is capable of being attached and detached in relation to the nozzle station 30, and is capable of performing, on the outside of the mounting machines 14, the collection of the suction nozzles 60 which are accommodated in the nozzle tray 77, the refilling of the nozzle tray 77 with the suction nozzles 60, and the like.

### <Mounting Work by Mounting Machine>

According to the configuration which is described above, in the mounting machine 14, it is possible to perform the mounting work on the circuit board which is held by the conveyance device 22 using the mounting head 26. Specifically, according to the instructions of the control device (not illustrated) of the mounting machine 14, the circuit board is conveyed to a working position, and at this position, is held in a fixed manner by the board holding device. The tape feeder 72 feeds out the taped components and supplies the electronic components to the supply position according to the instructions of the control device. The mounting head 26 moves above the supply position of the electronic components and sucks and holds the electronic component using the suction nozzle 60. Subsequently, the mounting head 26 moves above the circuit board, and the electronic component which is being held is mounted onto the circuit board.

### <Inspection of Suction Nozzle>

As described above, in the mounting machine 14, the electronic component which is supplied by the tape feeder 72 is sucked and held by the suction nozzle 60, and the electronic component is mounted onto the circuit board. Therefore, when a problem arises in the suction nozzle 60, it is not possible to perform appropriate mounting work. In consideration of this, the nozzle tray 77 is removed from the nozzle station 30 of the mounting machine 14, and the inspection of the suction nozzles 60 which are accommodated in the nozzle tray 77 is performed in the nozzle management device.

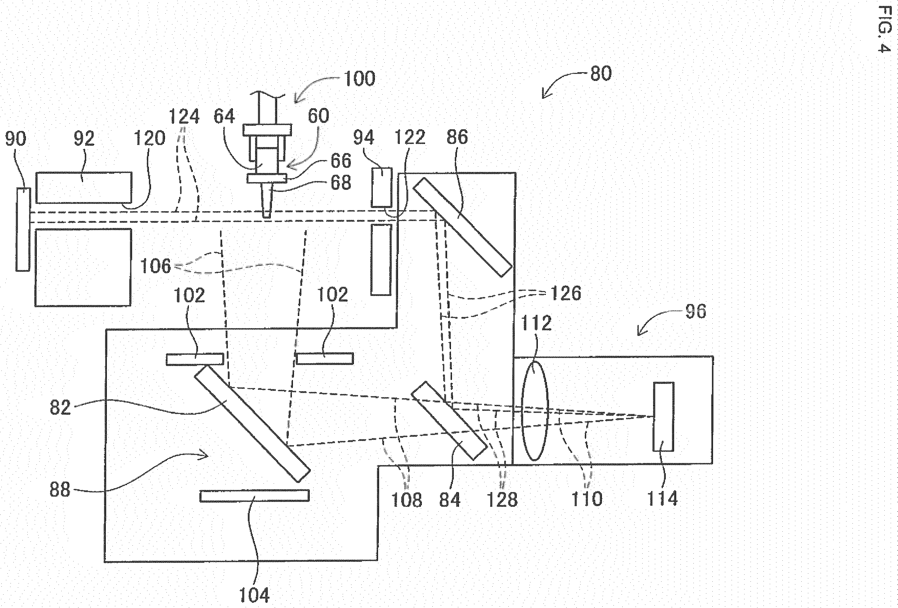

Specifically, as illustrated in Fig. 3, a nozzle management device 78 is a substantially rectangular parallelepiped shape, and a drawer 79 for storing the nozzle tray 77 inside the nozzle management device 78 or for removing the nozzle tray 77 from the nozzle management device 78 is provided on the front face. The suction nozzles 60 which are stored in the nozzle management device 78 are subjected to management and inspection in the nozzle management device 78. When inspecting the suction nozzle 60, the imaging of the suction nozzle 60 is performed, and inspection of the state of the suction pipe 68 of the suction nozzle 60 and the protrusion amount of the suction pipe 68 from the body cylinder 64 is performed based on the captured image data. As illustrated in Fig. 4, an imaging device 80 which performs the imaging of the suction nozzle 60 is provided with three reflecting mirrors 82, 84, and 86, a downward lighting device 88, a lateral lighting device 90, two light shielding blocks 92 and 94, and a camera 96.

In the nozzle management device 78, the inspection target suction nozzle 60 is gripped by a nozzle gripping tool 100. The suction nozzle 60 which is gripped by the nozzle gripping tool 100 is imaged by the imaging device 80. Of the three reflecting mirrors 82, 84, and 86, the first reflecting mirror 82 is installed under the suction nozzle 60 which is gripped by the nozzle gripping tool 100 in a state of being inclined by approximately 45°. The reflectance of the first reflecting mirror 82 is 50%, and the transmittance is 50%.

Of the three reflecting mirrors 82, 84, and 86, the second reflecting mirror 84 is installed to the side of the first reflecting mirror 82 in a state of being inclined by approximately 45° in the same direction as the first reflecting mirror 82. The reflectance of the second reflecting mirror 84 is 30%, and the transmittance is 70%. Of the three reflecting mirrors 82, 84, and 86, the third reflecting mirror 86 is installed above the second reflecting mirror 84 in a state of being inclined by approximately 45° in the same direction as the second reflecting mirror 84. The reflectance of the third reflecting mirror 86 is 100%, and the transmittance is 0%.

The downward lighting device 88 is provided with lateral lighting 102 and vertical lighting 104. The lateral lighting 102 is approximately annular and is installed between the first reflecting mirror 82 and the suction nozzle 60 which is gripped by the nozzle gripping tool 100 in a state of facing upward. An axial line of the suction nozzle 60 which is gripped by the nozzle gripping tool 100 substantially matches the center of the annular lateral lighting 102 in the up-down direction. The vertical lighting 104 is installed under the first reflecting mirror 82 in a state of facing upward. Accordingly, the lateral lighting 102 irradiates the suction nozzle 60 which is gripped by the nozzle gripping tool 100 with light from diagonally below, and the vertical lighting 104 irradiates the suction nozzle 60 which is gripped by the nozzle gripping tool 100 with light from directly below via the first reflecting mirror 82 and an inner diameter portion of the lateral lighting 102.

The light which is radiated from both of the lateral lighting 102 and the vertical lighting 104 is reflected by the lower end face of the suction pipe 68 of the suction nozzle 60 which is gripped by the nozzle gripping tool 100, travels along an optical path (a path between two dotted lines 106), and is incident on the first reflecting mirror 82. Of the light which is incident on the first reflecting mirror 82, 50% light amount of the light is reflected by the first reflecting mirror 82, travels along an optical path (a path between two dotted lines 108), and is incident on the second reflecting mirror 84. This is because the reflectance of the first reflecting mirror 82 is 50%. The camera 96 is installed on a line extending from the light which is incident on the second reflecting mirror 84. Therefore, of the light which is incident on the second reflecting mirror 84, 70% light amount of the light passes through the second reflecting mirror 84, travels along an optical path (a path between two dotted lines 110), and is incident on the camera 96.

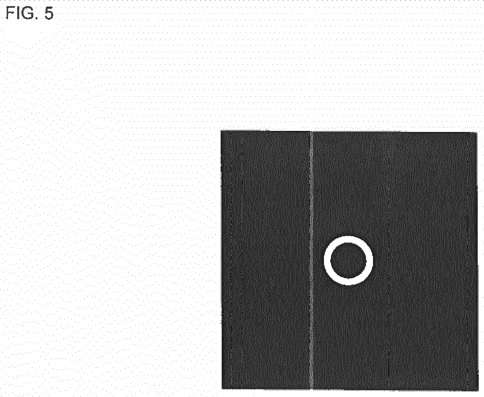

The camera 96 includes a lens 112 and an image sensor element 114, and the light which is incident on the camera 96 is detected by the image sensor element 114 via the lens 112. Incidentally, the light which is detected by the image sensor element 114 is light equivalent to 35% light amount (0.5 × 0.7 = 0.35) of the light which is reflected by the lower end face of the suction pipe 68 of the suction nozzle 60 which is gripped by the nozzle gripping tool 100. Accordingly, as illustrated in Fig. 5, an image of the lower end face of the suction pipe 68 of the suction nozzle 60 is obtained. Since the light which is detected by the image sensor element 114 is the light which is reflected by the lower end face of the suction pipe 68, the lower end face of the suction pipe 68 is indicated as white in the image. In this manner, by imaging the lower end face of the suction pipe 68 using the camera 96, it is possible to inspect the state of the suction pipe 68 of the suction nozzle 60.

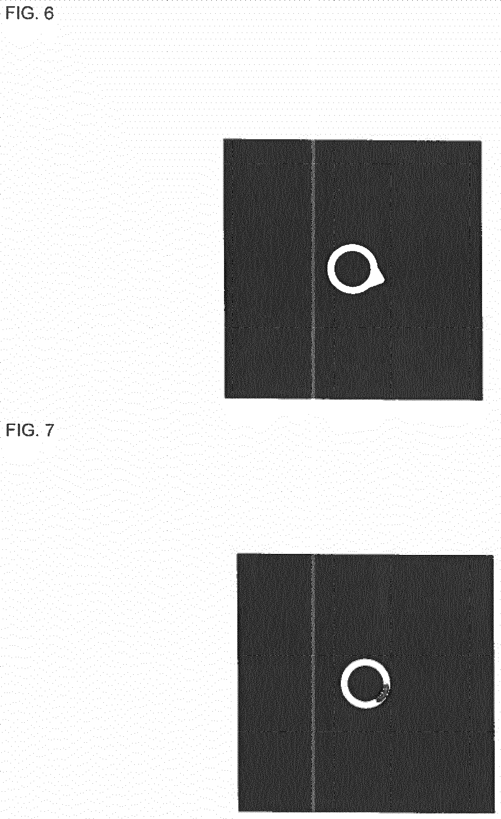

Specifically, for example, in a case in which foreign matter such as solder adheres to the outer edge side of the tip portion of the suction pipe 68 when the lower end face of the suction pipe 68 is imaged by the camera 96, the image illustrated in Fig. 6 is obtained. In this image, a protruding portion is illustrated on the outer edge side of the lower end face of the suction pipe 68, and due to this protruding portion, it is determined that foreign matter adheres to a tip portion of the suction pipe 68. Even in a case in which foreign matter adhered to the inner edge side of the tip portion of the suction pipe 68, naturally, since the protruding portion is illustrated on the inner edge side of the lower end face of the suction pipe 68 in the image which is imaged by the camera 96, it is determined that foreign matter adheres to the tip portion of the suction pipe 68.

In this manner, in a case in which the imaging of the lower end face of the suction pipe 68 is performed according to the procedure described above, that is, in a case in which imaging (hereinafter, there is a case in which this is denoted as "full irradiation imaging") based on the light which is reflected by the lower end face of the suction pipe 68 of the suction nozzle 60 is performed when the suction nozzle 60 is irradiated with the lighting of both the lateral lighting 102 and the vertical lighting 104, it is possible to appropriately determine the suction nozzle 60 in which foreign matter adheres to the outer edge side or the inner edge side of the tip portion of the suction pipe 68. However, in a case in which the foreign matter adheres to the lower end face of the suction pipe 68, there is a concern that it is not possible to appropriately determine the presence or the absence of the foreign matter using the image obtained when the full irradiation imaging is performed. In a case in which the lower end face of the suction pipe 68 is missing, there is a concern that it is not possible to appropriately determine whether or not the lower end face of the suction pipe 68 is missing using the image obtained when the full irradiation imaging is performed. In other words, in a case in which an abnormality arises in the lower end face of the suction pipe 68, there is a concern that it is not possible to appropriately determine the abnormality of the lower end face of the suction pipe 68 using the image obtained when the full irradiation imaging is performed.

Specifically, for example, the image obtained when the full irradiation imaging is performed on the suction nozzle 60 in which foreign matter adheres to the lower end face of the suction pipe 68 or is performed on the suction nozzle 60 in which a portion of the lower end face of the suction pipe 68 is missing is the image illustrated in Fig. 5. In other words, in a case in which foreign matter adheres to the lower end face of the suction pipe 68 or in a case in which a portion of the lower end face of the suction pipe 68 is missing, it is not possible to detect the adhesion of foreign matter or the tip portion of the suction pipe 68 being missing in the image obtained when the full irradiation imaging is performed.

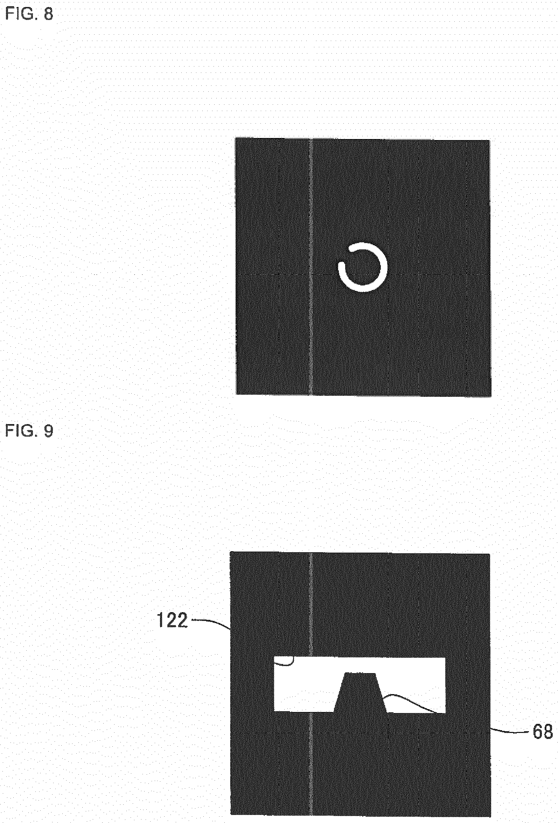

Meanwhile, in a case in which imaging based on the light which is reflected by the lower end face of the suction pipe 68 of the suction nozzle 60 when the suction nozzle 60 is irradiated with only the vertical lighting 104 is performed without being irradiated with the lateral lighting 102 (hereinafter, there is a case in which this is denoted as ''vertical irradiation imaging"), the state of the lower end face of the suction pipe 68 is appropriately imaged. Specifically, for example, in a case in which foreign matter adheres to the lower end face of the suction pipe 68, the suction nozzle 60 is irradiated with only the vertical lighting 104, and when the lower end face of the suction pipe 68 is imaged by the camera 96, the image illustrated in Fig. 7 is obtained. In this image, a black portion is present on the lower end face of the suction pipe 68, and due to this portion, it is determined that foreign matter adheres to the lower end face of the suction pipe 68. Specifically, for example, in a case in which a portion of the lower end face of the suction pipe 68 is missing, the suction nozzle 60 is irradiated with only the vertical lighting 104, and when the lower end face of the suction pipe 68 is imaged by the camera 96, the image illustrated in Fig. 8 is obtained. In this image, a portion of the lower end face of the suction pipe 68 is absent, and due to this absence, it is determined that a portion of the lower end face of the suction pipe 68 is missing.

However, during the vertical irradiation imaging, there is a concern that it is not possible to appropriately image foreign matter which adheres to the outer edge side or the inner edge side of the tip portion of the suction pipe 68. In other words, the image obtained when the vertical irradiation imaging is performed on the suction nozzle 60 in which foreign matter adheres to the outer edge side or the inner edge side of the tip portion of the suction pipe 68 is the image illustrated in Fig. 5. In other words, in a case in which foreign matter adheres to the outer edge side or the inner edge side of the tip portion of the suction pipe 68, it is not possible to detect the adhesion of foreign matter in the image obtained when the vertical irradiation imaging is performed.

In light of this fact, in the imaging device 80, the full irradiation imaging and the vertical irradiation imaging are performed and the state of the tip portion of the suction pipe 68 is inspected based on the image obtained when the full irradiation imaging is performed and the image obtained when the vertical irradiation imaging is performed. Therefore, in a case in which foreign matter adheres to the outer edge side or the inner edge side of the tip portion of the suction pipe 68, the adhesion of foreign matter is detected using the image obtained when the full irradiation imaging is performed. In a case in which foreign matter adheres to the lower end face of the suction pipe 68 or in a case in which the tip portion of the suction pipe 68 is missing, the adhesion of foreign matter or the tip portion of the suction pipe 68 being missing is detected using the image obtained when the vertical irradiation imaging is performed. Accordingly, it is possible to appropriately inspect the state of the tip portion of the suction pipe 68.

The shutter speed when the full irradiation imaging is performed is reduced to be slower than the shutter speed when the vertical irradiation imaging is performed. In other words, the light exposure time when the full irradiation imaging is performed is longer than the light exposure time when the vertical irradiation imaging is performed. Therefore, when the full irradiation imaging is performed, the image sensor element 114 is capable of detecting much of the light which is radiated from both of the lateral lighting 102 and the vertical lighting 104, and the contour of the image of the lower end face of the suction pipe 68 becomes clear in the image obtained when the full irradiation imaging is performed. Accordingly, it is possible to more appropriately detect foreign matter which adheres to the outer edge side or the inner edge side of the tip portion of the suction pipe 68. Meanwhile, during the vertical irradiation imaging, the detection amount of the light by the image sensor element 114 is reduced; however, in accordance with the reduction in the detection amount of the light, unevenness on the lower end face of the suction pipe 68 becomes clear in the image obtained when the vertical irradiation imaging is performed. Accordingly, it is possible to more appropriately detect foreign matter which adheres to the lower end face of the suction pipe 68 or to detect that the tip portion of the suction pipe 68 is missing.

In the nozzle management device 78, in addition to the inspection of the suction nozzle 60, cleaning of the suction nozzle 60 is also performed, and after the cleaning, the suction nozzle 60 is dried and stored in the nozzle management device 78. Therefore, there is a case in which whether or not water droplets remain on the suction nozzle 60 which is to be stored is inspected by the imaging device 80. There are many cases in which the water droplets which remain on the suction nozzle 60 remain on the lower end face of the suction pipe 68 or on the outer edge side or the inner edge side of the tip portion of the suction pipe 68. Therefore, according to the imaging device 80, it is possible to appropriately detect the water droplets which remain on the suction nozzle 60.

When the tip portion of the suction pipe 68 of the suction nozzle 60 is imaged from the side, the tip portion of the suction pipe 68 is irradiated from the side by the lateral lighting device 90. Specifically, the lateral lighting device 90 is a backlight system lighting device, and as illustrated in Fig. 4, irradiates the suction nozzle 60 which is gripped by the nozzle gripping tool 100 with light from the side and is installed such that the light with which the suction nozzle 60 is irradiated is incident on the third reflecting mirror 86. Of the two light shielding blocks 92 and 94, the first light shielding block 92 is installed between the lateral lighting device 90 and the suction nozzle 60 which is gripped by the nozzle gripping tool 100, and of the two light shielding blocks 92 and 94, the second light shielding block 94 is installed between the third reflecting mirror 86 and the suction nozzle 60 which is gripped by the nozzle gripping tool 100.

Slits 120 and 122 are formed in the first light shielding block 92 and the second light shielding block 94, respectively, and the two slits 120 and 122 match in the irradiation direction of the light from the lateral lighting device 90. Therefore, the lateral lighting device 90 irradiates the suction nozzle 60 which is gripped by the nozzle gripping tool 100 with light from the space of the slit 120 of the first light shielding block 92, and the irradiated light is incident on the third reflecting mirror 86 from the space of the slit 122 of the second light shielding block 94. At this time, the light which is radiated from the lateral lighting device 90 travels along an optical path (a path between two dotted lines 124) and is incident on the third reflecting mirror 86.

Of the light which is incident on the third reflecting mirror 86, 100% light amount of the light is reflected by the third reflecting mirror 86, travels along an optical path (a path between two dotted lines 126), and is incident on the second reflecting mirror 84. This is because the reflectance of the third reflecting mirror 86 is 100%. Next, of the light which is incident on the second reflecting mirror 84, 30% light amount of the light is reflected by the second reflecting mirror 84, travels along an optical path (a path between two dotted lines 128), and is incident on the camera 96. The light which is detected by the image sensor element 114 is light equivalent to 30% light amount (1.0 × 0.3 = 0.3) of the light which is radiated from the lateral lighting device 90. Accordingly, as illustrated in Fig. 9, an image of from the side of the suction pipe 68 of the suction nozzle 60 is obtained. Since the light which is detected by the image sensor element 114 is the light which passes through the space of the slit 122, the inner portion of the slit 122 is indicated as white in the image. Since a portion of the light which passes through the slit 122 is blocked by the suction pipe 68, the image of the suction pipe 68 is indicated as black.

According to the procedure described above, the inspection of the protrusion amount of the suction pipe 68 from the body cylinder 64 is performed by the suction pipe 68 of the suction nozzle 60 being imaged from the side. Specifically, the position of the tip portion of the suction pipe 68 is detected based on the image. The protrusion amount of the suction pipe 68 from the body cylinder 64 is calculated and whether or not the protrusion amount of the suction pipe 68 is an appropriate amount is determined based on the position of the tip portion of the suction pipe 68.

In this manner, in the imaging device 80, it is possible to perform the imaging of the lower end face and the imaging of the side of the suction nozzle 60 using the single camera 96. Accordingly, it is no longer necessary to use two cameras, a camera for the imaging of the lower end face of the suction nozzle 60 and a camera for the imaging of the side face, and it is possible to obtain a reduction in the cost of the imaging device.

Incidentally, in the example, the suction nozzle 60 is an example of an inspection target object. The imaging device 80 is an example of an inspection device. The camera 96 is an example of an imaging device. The lateral lighting 102 is an example of lateral lighting and second lighting. The vertical lighting 104 is an example of vertical irradiation and first lighting. The vertical irradiation lighting is an example of first irradiation lighting.

Note that, examples outside the scope of the claimed invention are not limited to the example described above, and it is possible to carry out the present invention in various modes subjected to various modifications and improvements based on the knowledge of a person skilled in the art. Specifically, for example, in the example described above, the full irradiation imaging and the vertical irradiation imaging are performed; however, in addition to the combination of the full irradiation imaging and the vertical irradiation imaging, it is possible to perform the imaging of a combination of the imaging of at least two of imaging which is based on light which is reflected by the lower end face of the suction pipe 68 of the suction nozzle 60 when the suction nozzle 60 is irradiated by only the lateral lighting 102 without the irradiation of the vertical lighting 104 (hereinafter, there are cases in which this is denoted as "lateral irradiation imaging"), full irradiation imaging, and vertical irradiation imaging. In other words, it is possible to perform each of the imaging of three of the full irradiation imaging, the vertical irradiation imaging, and the lateral lighting imaging, the imaging of two of the full irradiation imaging and the lateral lighting imaging, and the imaging of two of the vertical irradiation imaging and the lateral lighting imaging. Accordingly, it is possible to perform the inspection of the suction nozzle 60 according to the merits and the demerits of each kind of imaging and to appropriately perform the inspection of the suction nozzle 60. The lateral irradiation lighting is an example of second irradiation lighting.

The invention is exclusively defined by the appended claims.

### Reference Signs List

60: suction nozzle (inspection target object), 80: imaging device (inspection device), 96: camera (imaging device), 102: lateral lighting, 104: vertical lighting.

## Claims

1. An inspection device (80) for inspecting a suction nozzle (60) as an inspection target object (60) based on light with which the inspection target object (60) is irradiated, the device (80) comprising:
lateral lighting (102) which is configured to irradiate the inspection target object (60) with light from diagonally below, wherein the lateral lighting (102) is approximately annular, such that an axial line of the inspection target object (60) can substantially match the center of the annular lateral lighting (102) in an up-down direction, such that the inspection target object (60) is irradiated with light from diagonally below;
vertical lighting (104) which is configured to irradiate the inspection target object (60) with light from directly below via an inner portion of the lateral lighting (102);
and
an imaging device (96) which is configured to image the inspection target object (60) based on light which is reflected by the inspection target object (60) when the inspection target object (60) is irradiated from at least one of the vertical lighting (104) and the lateral lighting (102),
wherein the imaging device (96) is configured to perform full irradiation imaging which is imaging of the inspection target object (60) based on light which is reflected by the inspection target object (60) when the inspection target object (60) is irradiated from both the vertical lighting (104) and the lateral lighting (102), and vertical irradiation imaging which is imaging of the inspection target object (60) based on light which is reflected by the inspection target object (60) when the inspection target object (60) is irradiated from the vertical lighting (104) without being irradiated from the lateral lighting (102), and optionally, is configured to perform lateral irradiation imaging which is imaging of the inspection target object (60) based on light which is reflected by the inspection target object (60) when the inspection target object (60) is irradiated from the lateral lighting (102) without being irradiated from the vertical lighting (104),
when the imaging device (96) performs first imaging from among the full irradiation imaging, the vertical irradiation imaging, and the lateral irradiation imaging, and second imaging, different from the first imaging, from among the full irradiation imaging, the vertical irradiation imaging, and the lateral irradiation imaging, a shutter speed during the first imaging and a shutter speed during the second imaging are changed, and
the shutter speed, when the full irradiation imaging is performed, is reduced to be slower than the shutter speed when the vertical irradiation imaging is performed.

2. The inspection device (80) according to Claim 1,
wherein the imaging device (96) is configured to perform all of the full irradiation imaging, the vertical irradiation imaging, and the lateral irradiation imaging.

3. The inspection device (80) according to Claim 1 or 2,
wherein the inspection target object (60) includes an end surface which faces at least one of the vertical lighting (104) and the lateral lighting (102), and
wherein the end surface of the inspection target object (60) is inspected based on an image which is obtained using first imaging from among the full irradiation imaging, the vertical irradiation imaging, and the lateral irradiation imaging, and a portion other than the end surface of the inspection target object (60) is inspected based on an image which is obtained using second imaging, different from the first imaging, from among the full irradiation imaging, the vertical irradiation imaging, and the lateral irradiation imaging.

4. An inspection method for inspecting a suction nozzle (60) as an inspection target object (60) using an inspection device (80) including vertical lighting (104) which irradiates the inspection target object (60) with light from directly below, wherein the lateral lighting (102) is approximately annular, such that an axial line of the inspection target object (60) can substantially match the center of the annular lateral lighting (102) in an up-down direction, such that the inspection target object (60) is irradiated with light from diagonally below, lateral lighting (102) which irradiates the inspection target object (60) with light from diagonally below via an inner portion of the lateral lighting (102), and an imaging device (96) which images the inspection target object (60) based on light which is reflected by the inspection target object (60) when the inspection target object (60) is irradiated from at least one of the vertical lighting (104) and the lateral lighting (102),
the method further comprising:
an imaging step of causing the imaging device (96) to perform full irradiation imaging which is imaging of the inspection target object (60) based on light which is reflected by the inspection target object (60) when the inspection target object (60) is irradiated from both the vertical lighting (104) and the lateral lighting (102), and vertical irradiation imaging which is imaging of the inspection target object (60) based on light which is reflected by the inspection target object (60) when the inspection target object (60) is irradiated from the vertical lighting (104) without being irradiated from the lateral lighting (102), and optionally, to perform lateral irradiation imaging which is imaging of the inspection target object (60) based on light which is reflected by the inspection target object (60) when the inspection target object (60) is irradiated from the lateral lighting (102) without being irradiated from the vertical lighting (104); and
an inspection step of inspecting the inspection target object (60) based on images which are obtained using the at least two imaging processes which are performed in the imaging step, when the imaging device (96) is caused to perform first imaging from among the full irradiation imaging, the vertical irradiation imaging, and the lateral irradiation imaging, and second imaging, different from the first imaging, from among the full irradiation imaging, the vertical irradiation imaging, and the lateral irradiation imaging, a shutter speed during the first imaging and a shutter speed during the second imaging are changed, and
the shutter speed, when the full irradiation imaging is performed, is reduced to be slower than the shutter speed when the vertical irradiation imaging is performed.

## Patentansprüche

1. Inspektionsvorrichtung (80) zum Inspizieren einer Saugdüse (60) als Inspektionszielobjekt (60) auf Grundlage von Licht, mit dem das Inspektionszielobjekt (60) bestrahlt wird, wobei die Vorrichtung (80) umfasst:
eine laterale Beleuchtung (102), die so konfiguriert ist, dass sie das Inspektionszielobjekt (60) mit Licht von unten diagonal bestrahlt, wobei die laterale Beleuchtung (102) näherungsweise ringförmig ist, so dass eine Achsenlinie des Inspektionszielobjekts (60) im Wesentlichen mit der Mitte der ringförmigen lateralen Beleuchtung (102) in der Oben-Unten-Richtung übereinstimmen kann, so dass das Inspektionszielobjekt (60) mit Licht von unten diagonal bestrahlt wird;
eine vertikale Beleuchtung (104), die so konfiguriert ist, dass sie das Inspektionszielobjekt (60) mit Licht von direkt unten über einen inneren Abschnitt der lateralen Beleuchtung (102) bestrahlt;
und
eine Bildgebungsvorrichtung (96), die konfiguriert ist, dass sie das Inspektionszielobjekt (60) auf Grundlage von Licht abbildet, das von dem Inspektionszielobjekt (60) reflektiert wird, wenn das Inspektionszielobjekt (60) von mindestens einer der vertikalen Beleuchtungen (104) und der lateralen Beleuchtungen (102) bestrahlt wird,
wobei
die Bildgebungsvorrichtung (96) so konfiguriert ist, dass sie eine Vollbestrahlungsbildgebung durchführt, bei der das Inspektionszielobjekt (60) auf Grundlage von Licht abgebildet wird, das vom Inspektionszielobjekt (60) reflektiert wird, wenn das Inspektionszielobjekt (60) sowohl von der vertikalen Beleuchtung (104) als auch von der lateralen Beleuchtung (102) bestrahlt wird, und eine vertikale Bestrahlungsbildgebung, bei der das Inspektionszielobjekt (60) auf Grundlage von Licht abgebildet wird, das vom Inspektionszielobjekt (60) reflektiert wird, wenn das Inspektionszielobjekt (60) von der vertikalen Beleuchtung (104) bestrahlt wird, ohne von der lateralen Beleuchtung (102) bestrahlt zu werden, und optional so konfiguriert ist, dass sie eine laterale Bestrahlungsbildgebung durchführt, bei der das Inspektionszielobjekt (60) auf Grundlage von Licht abgebildet wird, das vom Inspektionszielobjekt (60) reflektiert wird, wenn das Inspektionszielobjekt (60) von der lateralen Beleuchtung (102) bestrahlt wird, ohne von der vertikalen Beleuchtung (104) bestrahlt zu werden,
wenn die Bildgebungsvorrichtung (96) eine erste Bildgebung aus der Vollbestrahlungsbildgebung, der vertikalen Bestrahlungsbildgebung und der lateralen Bestrahlungsbildgebung, und eine zweite Bildgebung, die sich von der ersten Bildgebung unterscheidet, aus der Vollbestrahlungsbildgebung, der vertikalen Bestrahlungsbildgebung und der lateralen Bestrahlungsbildgebung ausführt, werden eine Verschlusszeit während der ersten Bildgebung und eine Verschlusszeit während der zweiten Bildgebung geändert, und
die Verschlusszeit wird, wenn die Vollbestrahlungsbildgebung durchgeführt wird, so verringert, dass sie langsamer ist als die Verschlusszeit, wenn die vertikale Bestrahlungsbildgebung durchgeführt wird.

2. Die Inspektionsvorrichtung (80) gemäß Anspruch 1,
wobei die Bildgebungsvorrichtung (96) so konfiguriert ist, dass sie sowohl die Vollbestrahlungsbildgebung als auch die vertikale Bestrahlungsbildgebung und die laterale Bestrahlungsbildung durchführt.

3. Inspektionsvorrichtung (80) gemäß Anspruch 1 oder 2, wobei das Inspektionszielobjekt (60) eine Endfläche aufweist, die mindestens einer der vertikalen Beleuchtung (104) und der lateralen Beleuchtung (102) zugewandt ist, und
wobei die Endfläche des Inspektionszielobjekts (60) auf Grundlage eines Bildes inspiziert wird, das unter Verwendung einer ersten Bildgebung aus der Vollbestrahlungsbildgebung, der vertikalen Bestrahlungsbildgebung und der lateralen Bestrahlungsbildgebung erhalten wird, und ein anderer Teil als die Endfläche des Inspektionszielobjekts (60) auf Grundlage eines Bildes inspiziert wird, das unter Verwendung einer zweiten Bildgebung, die sich von der ersten Bildgebung unterscheidet, aus der Vollbestrahlungsbildgebung, der vertikalen Bestrahlungsbildgebung und der lateralen Bestrahlungsbildgebung erhalten wird.

4. Ein Inspektionsverfahren zum Prüfen einer Saugdüse (60) als Inspektionszielobjekt (60) unter Verwendung einer Inspektionsvorrichtung (80) mit vertikaler Beleuchtung (104), die das Inspektionszielobjekt (60) mit Licht von direkt unten bestrahlt, wobei die laterale Beleuchtung (102) näherungsweise ringförmig sind, so dass eine Achsenlinie des Inspektionszielobjekts (60) im Wesentlichen mit der Mitte der ringförmigen lateralen Beleuchtung (102) in Auf-Ab-Richtung übereinstimmen kann, so dass das Inspektionszielobjekt (60) mit Licht von unten diagonal bestrahlt wird, einer lateralen Beleuchtung (102), die das Inspektionszielobjekt (60) mit Licht von unten diagonal über einen inneren Teil der lateralen Beleuchtung (102) bestrahlt, und einer Bildgebungsvorrichtung (96), die das Inspektionszielobjekt (60) auf Grundlage von Licht abbildet, das von dem Inspektionszielobjekt (60) reflektiert wird, wenn das Inspektionszielobjekt (60) von mindestens einer der vertikalen Beleuchtung (104) und der lateralen Beleuchtung (102) bestrahlt wird,
wobei das Verfahren ferner umfasst:
einen Abbildungsschritt, bei dem die Bildgebungsvorrichtung (96) eine Vollbestrahlungsbildgebung durchführt, bei der das Inspektionszielobjekt (60) auf Grundlage von Licht abgebildet wird, das vom Inspektionszielobjekt (60) reflektiert wird, wenn das Inspektionszielobjekt (60) sowohl von der vertikalen Beleuchtung (104) als auch von der lateralen Beleuchtung (102) bestrahlt wird, und eine vertikale Bestrahlungsbildgebung, bei der das Inspektionszielobjekt (60) auf Grundlage von Licht abgebildet wird, das vom Inspektionszielobjekt (60) reflektiert wird, wenn das Inspektionszielobjekt (60) von der vertikalen Beleuchtung (104) bestrahlt wird, ohne von der lateralen Beleuchtung (102) bestrahlt zu werden, und optional, eine laterale Bestrahlungsbildgebung durchzuführen, bei der das Inspektionszielobjekt (60) auf Grundlage von Licht abgebildet wird, das vom Inspektionszielobjekt (60) reflektiert wird, wenn das Inspektionszielobjekt (60) von der lateralen Beleuchtung (102) bestrahlt wird, ohne von der vertikalen Beleuchtung (104) bestrahlt zu werden; und
einen Inspektionsschritt zum Inspizieren des Inspektionszielobjekts (60) auf Grundlage von Bildern, die unter Verwendung der mindestens zwei Bildgebungsverfahren erhalten werden, die im Bildgebungsschritt durchgeführt werden,
wenn die Bildgebungsvorrichtung (96) veranlasst wird, eine erste Bildgebung aus der Vollbestrahlungsbildgebung, der vertikalen Bestrahlungsbildgebung und der seitlichen Bestrahlungsbildgebung und eine zweite Bildgebung, die sich von der ersten Bildgebung unterscheidet, aus der Vollbestrahlungsbildgebung, der vertikalen Bestrahlungsbildgebung und der lateralen Bestrahlungsbildgebung auszuführen, werden eine Verschlusszeit während der ersten Bildgebung und eine Verschlusszeit während der zweiten Bildgebung geändert, und
die Verschlusszeit wird, wenn die Vollbestrahlungsbildgebung durchgeführt wird, so verringert, dass sie langsamer ist als die Verschlusszeit, wenn die vertikale Bestrahlungsbildgebung durchgeführt wird.

## Revendications

1. Dispositif d'inspection (80) destiné à inspecter une buse d'aspiration (60) en tant qu'objet cible d'inspection (60) en fonction de la lumière avec laquelle l'objet cible d'inspection (60) est irradié, le dispositif (80) comprenant:
un éclairage latéral (102) configuré pour irradier l'objet cible d'inspection (60) avec de la lumière provenant de manière diagonale par le dessous, dans lequel l'éclairage latéral (102) est approximativement annulaire, de telle sorte qu'une ligne axiale de l'objet cible d'inspection (60) puisse correspondre sensiblement au centre de l'éclairage latéral annulaire (102) dans une direction verticale, de telle sorte que l'objet cible d'inspection (60) soit irradié par la lumière provenant en diagonale par le dessous;
un éclairage vertical (104) configuré pour irradier l'objet cible d'inspection (60) avec de la lumière provenant directement d'en dessous via une partie interne de l'éclairage latéral (102);
et
un dispositif d'imagerie (96) configuré pour former une image de l'objet cible d'inspection (60) en fonction de la lumière qui est réfléchie par l'objet cible d'inspection (60) lorsque l'objet cible d'inspection (60) est irradié à partir d'au moins l'un de l'éclairage vertical (104) et de l'éclairage latéral (102),
dans lequel le dispositif d'imagerie (96) est configuré pour effectuer une imagerie à irradiation complète qui consiste à former une image de l'objet cible d'inspection (60) en fonction de la lumière réfléchie par l'objet cible d'inspection (60) lorsque l'objet cible d'inspection (60) est irradié à la fois par l'éclairage vertical (104) et l'éclairage latéral (102), et une imagerie par irradiation verticale qui est une imagerie de l'objet cible d'inspection (60) en fonction de la lumière qui est réfléchie par l'objet cible d'inspection (60) lorsque l'objet cible d'inspection (60) est irradié par l'éclairage vertical (104) sans être irradié par l'éclairage latéral (102), et, en option, est configuré pour effectuer une imagerie par irradiation latérale qui est une imagerie de l'objet cible d'inspection (60) en fonction de la lumière qui est réfléchie par l'objet cible d'inspection (60) lorsque l'objet cible d'inspection (60) est irradié par l'éclairage latéral (102) sans être irradié par l'éclairage vertical (104),
lorsque le dispositif d'imagerie (96) effectue une première imagerie parmi l'imagerie à irradiation complète, l'imagerie à irradiation verticale et l'imagerie à irradiation latérale, et une seconde imagerie, différente de la première imagerie, parmi l'imagerie à irradiation complète, l'imagerie à irradiation verticale et l'imagerie à irradiation latérale, la vitesse d'obturation pendant la première imagerie et la vitesse d'obturation pendant la seconde imagerie sont modifiées, et
la vitesse d'obturation, lorsque l'imagerie à irradiation complète est effectuée, est réduite pour être plus lente que la vitesse d'obturation lorsque l'imagerie à irradiation verticale est effectuée.

2. Dispositif d'inspection (80) selon la revendication 1,
dans lequel le dispositif d'imagerie (96) est configuré pour effectuer à la fois l'imagerie à irradiation complète, l'imagerie à irradiation verticale et l'imagerie à irradiation latérale.

3. Dispositif d'inspection (80) selon les revendications 1 ou 2,
dans lequel l'objet cible d'inspection (60) comprend une surface d'extrémité qui fait face à au moins l'un des éléments suivants : éclairage vertical (104) et éclairage latéral (102), et
dans lequel la surface d'extrémité de l'objet cible d'inspection (60) est inspectée en fonction d'une image obtenue à l'aide d'une première imagerie parmi l'imagerie à irradiation complète, l'imagerie à irradiation verticale et l'imagerie à irradiation latérale, et une partie autre que la surface d'extrémité de l'objet cible d'inspection (60) est inspectée en fonction d'une image obtenue à l'aide d'une seconde imagerie, différente de la première imagerie, parmi l'imagerie à irradiation complète, l'imagerie à irradiation verticale et l'imagerie à irradiation latérale.

4. Procédé d'inspection pour inspecter une buse d'aspiration (60) en tant qu'objet cible d'inspection (60) à l'aide d'un dispositif d'inspection (80) comprenant un éclairage vertical (104) qui irradie l'objet cible d'inspection (60) avec de la lumière provenant directement du dessous, dans lequel l'éclairage latéral (102) est approximativement annulaire, de telle sorte qu'une ligne axiale de l'objet cible d'inspection (60) puisse correspondre sensiblement au centre de l'éclairage latéral annulaire (102) dans une direction verticale, de telle sorte que l'objet cible d'inspection (60) soit irradié par de la lumière provenant en diagonale par le dessous, un éclairage latéral (102) qui irradie l'objet cible d'inspection (60) avec de la lumière provenant en diagonale par le dessous via une partie interne de l'éclairage latéral (102), et un dispositif d'imagerie (96) qui forme une image de l'objet cible d'inspection (60) en fonction de la lumière réfléchie par l'objet cible d'inspection (60) lorsque l'objet cible d'inspection (60) est irradié par au moins l'un des éléments suivants : éclairage vertical (104) et éclairage latéral (102),
le procédé comprenant en outre:
une étape d'imagerie consistant à amener le dispositif d'imagerie (96) à effectuer une imagerie à irradiation complète qui consiste à former une image de l'objet cible d'inspection (60) en fonction de la lumière réfléchie par l'objet cible d'inspection (60) lorsque l'objet cible d'inspection (60) est irradié à la fois par l'éclairage vertical (104) et l'éclairage latéral (102), et une imagerie par irradiation verticale qui est une imagerie de l'objet cible d'inspection (60) en fonction de la lumière réfléchie par l'objet cible d'inspection (60) lorsque l'objet cible d'inspection (60) est irradié par l'éclairage vertical (104) sans être irradié par l'éclairage latéral (102), et, éventuellement, pour effectuer une imagerie par irradiation latérale qui est une imagerie de l'objet cible d'inspection (60) en fonction de la lumière qui est réfléchie par l'objet cible d'inspection (60) lorsque l'objet cible d'inspection (60) est irradié par l'éclairage latéral (102) sans être irradié par l'éclairage vertical (104); et
une étape d'inspection consistant à inspecter l'objet cible d'inspection (60) en fonction d'images obtenues à l'aide d'au moins deux processus d'imagerie effectués lors de l'étape d'imagerie, lorsque le dispositif d'imagerie (96) est amené à effectuer une première imagerie parmi l'imagerie à irradiation complète, l'imagerie à irradiation verticale et l'imagerie à irradiation latérale, et une seconde imagerie, différente de la première imagerie, parmi l'imagerie à irradiation complète, l'imagerie à irradiation verticale et l'imagerie à irradiation latérale, une vitesse d'obturation pendant la première imagerie et une vitesse d'obturation pendant la seconde imagerie sont modifiées, et
la vitesse d'obturation, lorsque l'imagerie à irradiation complète est effectuée, est réduite pour être plus lente que la vitesse d'obturation lorsque l'imagerie à irradiation verticale est effectuée.
